# EUROPÄISCHE PATENTSCHRIFT

(11) **EP 2 963 343 B1**
(45) Veröffentlichungstag und Bekanntmachung des Hinweises auf die Patenterteilung: **28.06.2017**
(21) Anmeldenummer: 14175892.0
(22) Anmeldetag: 05.07.2014
(51) Int. Cl.: F21V 29/70, F21K 9/20, F21V 29/83, H05K 1/02, F21V 5/04, F21V 17/10, F21V 19/00, F21V 19/04, F21V 29/89, F21V 31/03, F21V 31/04, F21W 131/10, F21W 131/101, F21W 131/105, F21Y 101/00, F21Y 105/10, F21Y 115/10, H05K 3/00

(54) **Linsenanordnung für eine Beleuchtungsvorrichtung und Beleuchtungsvorrichtung**
Array of lenses for a lighting device and lighting device
Disposition de lentilles pour un dispositif d'illumination et dispositif d'illumination

(43) Veröffentlichungstag der Anmeldung: 06.01.2016
(73) Patentinhaber: Swareflex GmbH, 6134 Vomp (AT)
(72) Erfinder: Reisigl, Harald, 6130 Schwaz (AT)
(74) Vertreter: dompatent von Kreisler Selting Werner - Partnerschaft von Patent- und Rechtsanwälten mbB

(56) Entgegenhaltungen:
- DE-A1-102012 101 411
- DE-U1-202011 003 828
- US-A1- 2004 135 482
- US-A1- 2014 126 205

## Beschreibung

### GEBIET DER ERFINDUNG

Die Erfindung betrifft eine Beleuchtungsvorrichtung nach dem Oberbegriff des Patentanspruchs 1, so wie sie z.B. aus DE 102012 101 411 A1 bekannt ist.

### STAND DER TECHNIK

Beleuchtungsvorrichtungen dienen einer Ausleuchtung bzw. Beleuchtung eines Raumes oder einer Fläche. Der Vorteil einer Lichtquelle der Beleuchtungsvorrichtung in Form von Leuchtdioden, so genannten LEDs, gegenüber Glühlampen ist eine höhere Lebensdauer bei gleichzeitig geringerem Stromverbrauch. Des Weiteren können sie an Orten eingesetzt werden, bei denen andere Lichtquellen nicht verwendet werden dürfen, da etwa Brandschutzgründe dagegen sprechen. Sie entwickeln wenig Wärme und geben keine IR-oder UV-Strahlung ab. Ein weiterer Vorteil gegenüber üblichen Energiesparlampen ist, dass sie ab der ersten Sekunde das volle Licht abgeben und keine Verzögerung haben. Auch in Bezug auf Umweltfreundlichkeit weisen mit LED-Lichtquellen ausgestattete Beleuchtungsvorrichtungen einen großen Vorteil auf. Weder Blei noch Quecksilber sind in den LED-Lichtquellen enthalten und durch ihre Sparsamkeit sinkt die CO² -Belastung des Klimas deutlich.

Sie bieten eine große Flexibilität in ihrem Einsatzbereich. So können kleine und große Flächen oder Räume an- bzw. ausgeleuchtet werden, sowohl in einem Innen- als auch in einem Außenbereich. Je nach Größe der aus- bzw. anzuleuchtenden Fläche oder des aus- bzw. anzuleuchtenden Raumes kommen mehr oder weniger der einzelnen Leuchtdioden in Einsatz. Des Weiteren lässt sich eine konturierte Abgrenzung der auszuleuchtenden Fläche bzw. des auszuleuchtenden Raumes erzielen. Mit anderen Worten kann eine scharfe Beleuchtungsgrenze beim Einsatz von Leuchtdioden geschaffen werden.

Beleuchtungsvorrichtungen mit LED-Lichtquellen werden auch im Bereich von bspw. Tunnel, Flughäfen und Stadien eingesetzt, also dort, wo große Flächen oder Räume auszuleuchten sind. Hierzu sind Leuchtdioden, welche von einer Linse in deren Hohlraum aufgenommen sind, auf einer Leiterplatte der Beleuchtungsvorrichtung angeordnet. Mit anderen Worten ist eine Linsenanordnung ausgebildet, welche eine Leuchtdiode, eine Linse und eine Leiterplatte umfasst.

So geht aus der Offenlegungsschrift DE 10 2011 111 953 A1 eine Linsenanordnung für eine Tunnelleuchte hervor, wobei die Linsenanordnung in einem Träger der Tunnelleuchte aufgenommen ist. Die Linsen sind LEDs umfassend auf einer Leiterplatte der Tunnelleuchte mit Hilfe eines Kunstharzes an ihren Grundflächen festgeklebt. Die Leiterplatte wird an einer Montagefläche des Trägers aufgenommen. Zur Belüftung und damit zur Wärmeabfuhr der von den Lichtquellen freigesetzten Wärme sind im Bereich der LEDs so genannte VIAs in der Leiterplatte ausgebildet. Diese VIAs dienen einer Belüftung eines Hohlraums der Linse in welchem die Leuchtdiode platziert ist. Dabei wird die von der Leuchtdiode freigesetzte Wärme über eine metallische Schicht der VIAs auf eine von der Leuchtdiode abgewandt angeordnet Rückseite der Leiterplatte transportiert. Problematisch ist, dass unter Umständen die zur Verfügung gestellte Belüftung aufgrund der direkten Montage der Leiterplatte an den Träger nicht ausreicht um eine hinreichende Belüftung bereitzustellen, so dass eine hohe Lebensdauer der Leuchtdiode und damit der Linsenanordnung zuverlässig realisiert wäre. Des Weiteren ist bei einem Ausfall einer Leuchtdiode die gesamte Leiterplatte auf welcher die Linsen mit den Leuchtdioden angeordnet sind, aus dem Träger zu entfernen, wodurch ein hoher Kostenaufwand entsteht.

Somit ist es die Aufgabe der vorliegenden Erfindung eine Linsenanordnung für eine Beleuchtungsvorrichtung bereitzustellen, welche einfach und praxistauglich demontierbar ist. Eine weitere Aufgabe der Erfindung ist es, eine Beleuchtungsvorrichtung mit einem leicht zu wartenden Aufbau bereitzustellen.

### BESCHREIBUNG DER ERFINDUNG

Die Aufgabe wird erfindungsgemäß durch eine Linsenanordnung für eine Beleuchtungsvorrichtung mit den Merkmalen das Patentanspruchs 1 gelöst. Vorteilhafte Ausgestaltungen mit zweckmäßigen und nicht-trivialen Weiterbildungen der Erfindung sind in den jeweiligen Unteransprüchen angegeben.

Die erfindungsgemäße Linsenanordnung für eine Beleuchtungsvorrichtung, umfasst eine Lichtquelle in Form einer Leuchtdiode, die auf einer Leiterplatte fixiert ist. Die Leuchtdiode ist an einer ersten Leiterplattenfläche der Leiterplatte ausgebildet und von einer Linse in einem Hohlraum der Linse von dieser umfassend aufgenommen. Die Linse weist eine der Leuchtdiode zugewandt ausgebildete ebene Positionierfläche auf, welche an der ersten Leiterplattenfläche fixiert ist. Die Linsenanordnung weist eine Trägerplatte auf, welche mit einem Träger der Beleuchtungsvorrichtung lösbar verbindbar ist, wobei die Trägerplatte die Leiterplatte aufnehmbar ausgebildet ist.

Der Vorteil dieser Linsenanordnung ist eine problemlose Montierung und Demontierbarkeit der Linsenanordnung an einem Träger der Beleuchtungsvorrichtung. Mit Leuchtdioden bestückte Leiterplatten erfordern, unabhängig von einer hohen Schmutz- und insbesondere Fettempfindlichkeit der Leiterplatte, eine behutsame Behandlung, da es aufgrund der filigranen Bauteile schnell zu einer Beschädigung der Linsenanordnung kommen kann. Die Trägerplatte führt eine Stabilisierung der Linsenanordnung und eine verbesserte Handhabbarkeit der Linsenanordnung herbei, da die Linsenanordnung an der Trägerplatte problemlos entweder mit Hilfe eines Werkzeugs oder manuell ergriffen werden kann.

Zur Ausleuchtung großer Flächen und Bereiche werden üblicherweise mehrere Leuchtdioden eingesetzt. Eine einfache Handhabung und insbesondere eine einfache Wartung der Beleuchtungsvorrichtung ist mit der erfindungsgemäßen Linsenanordnung herbeizuführen, da ein modularer Aufbau der Lichtquelle der Beleuchtungsvorrichtung mit Hilfe einer Mehrzahl von Linsenanordnungen möglich ist. Die Linsenanordnung kann eine Leiterplatte aufweisen, welche mit einer Mehrzahl von Linsen aufweisend je eine Leuchtdiode bestückt ist. Sofern nun ein oder mehrere Elemente einer Linsenanordnung defekt sind, kann aus der Mehrzahl der Linsenanordnungen problemlos ein Austausch der die defekten Elemente aufweisende Linsenanordnung aus der Beleuchtungsvorrichtung vorgenommen werden, ohne die gesamte Mehrzahl der Linsenanordnungen von der Beleuchtungsvorrichtung zu demontieren. Dies führt zum einen zu einer Kostenreduktion der Austauschteile und zum anderen zu einer Reduktion des Zeitaufwandes der Instanthaltung der Beleuchtungsvorrichtung.

Dieser Vorteil ist unabhängig davon, ob die Leiterplatte, welche an der Trägerplatte aufgenommen ist, eine einzige Linse mit einer Leuchtdiode aufweist, oder eine Mehrzahl an Linsen mit je einer Leuchtdiode. Ebenso können die Linsen auch matrixartig auf der Leiterplatte angeordnet sein. Es sei an dieser Stelle erwähnt, dass eine Linse nicht zwangsläufig eine einzig Leuchtdiode umfassend ausgebildet sein muss, sondern die Linse ist mindestens eine Leuchtdiode umfassend ausgebildet. Das heißt mit anderen Worten, dass die Linse auch eine oder mehrere Leuchtdiode umfassend ausgebildet sein kann.

In einer weiteren vorteilhaften Ausgestaltung der erfindungsgemäßen Linsenanordnung ist die Trägerplatte zur Wärmeabfuhr einer von der Leuchtdiode erzeugten Wärmemenge ausgebildet ist. Der Vorteil dieser Ausgestaltung ist eine Erhöhung der Lebensdauer der Linsenanordnung. Der Umgang mit Wärme gilt als ein entscheidendes Qualitätskriterium von Leuchten, die mit Leuchtdioden ausgerüstet sind. Leuchtdioden setzen ca. 70% der aufgenommenen elektrischen Energie in Wärme um. Die Linse soll sich nur gering erhitzen. Ist die Beleuchtungsvorrichtung, d.h. insbesondere der die Linsenanordnung aufnehmende Träger nicht entsprechend konzipiert genügend Wärme abzuleiten, bedeutet dies eine Verkürzung der Lebensdauer. Dies kann in einfacher Weise durch ein entsprechend gewähltes Material, welches eine hohe Wärmeleitfähigkeit wie bspw. Aluminium aufweist, realisiert sein. Eine Wärmeabfuhr ist auch durch ein entsprechendes Design der Trägerplatte zu realisieren, indem bspw. Rippen an der Umgebung zugewandt ausgebildeten Seitenflächen der Trägerplatte ausgestaltet sind.

Eine weitere Erhöhung der Lebensdauer ist bei einer Ausbildung der Trägerplatte mit einem Kanalsystem zur Belüftung der Linsenanordnung realisiert. Das Kanalsystem zur Belüftung der Linsenanordnung dient einer Kühlung der Linsenanordnung. Die in Wärme umgesetzte Energie der Leuchtdioden kann nun verbessert mit Hilfe der in dieser Ausbildung in Form einer als Kühlkörper ausgebildeten Trägerplatte abgeführt werden. Ein weiterer Vorteil ist, dass eine Lichtstromleistung der Linsenanordnung aufgrund des Kühlkörpers in Form der Trägerplatte erhöht werden kann. Ein weiterer Vorteil ist eine Redzierung des Gewichts der Trägerplatte aufgrund des in der Trägerplatte ausgebildeten Kanalsystems.

Der Hohlraum der Linse begrenzt eine Freifläche der ersten Leiterplattenfläche, innerhalb derer die Leuchtdiode positioniert ist. Innerhalb dieser Freifläche ist eine die Leiterplatte vollständig durchdringende Durchtrittsöffnung ausgebildet, welche eine Eintrittsfläche an der ersten Leiterplattenfläche und eine Austrittsfläche aufweist, die an einer von der ersten Leiterplattenfläche abgewandt ausgebildeten zweiten Leiterplattenfläche ausgestaltet ist. Die Austrittsfläche ist mit dem zumindest teilweise in der Trägerplatte ausgebildeten Kanalsystem zur Wärmeabfuhr kommunizierend ausgestaltet. Das bedeutet, dass nicht nur über die Leiterplatte eine Wärmeabfuhr infolge Wärmeleitung erfolgt, sondern die Durchtrittsöffnung ist in Form eines Belüftungskanals ausgebildet, welcher durchströmbar mit dem Kanalsystem der Trägerplatte zur Belüftung verbunden ist. Dadurch kann der Hohlraum, in dem die Leuchtdiode aufgenommen ist, verbessert gekühlt werden, wodurch die Lebensdauer der Leuchtdiode und somit der Linsenanordnung verlängert wird.

In einer weiteren vorteilhaften Ausgestaltung ist ausgehend von der Austrittsfläche der Durchtrittsöffnung ein mit dem Kanalsystem kommunizierendes weiteres Kanalsystem an der zweiten Leiterplattenfläche ausgebildet. Dieses weitere Kanalsystem dient insbesondere einer durchströmbaren Verbindung mehrerer Austrittsflächen an der zweiten Leiterplattenfläche. Somit ist es ausreichend, wenn die Trägerplatte nur einen Verbindungskanal aufweist, welcher das Kanalsystem der Trägerplatte mit dem weiteren Kanalsystem verbindet. Ein Austritt des Verbindungskanal ist an einer ersten Trägerplattenfläche der Trägerplatte ausgebildet, wobei dieser Austritt mit einem Bereich des weiteren Kanalsystems in Überdeckung gebracht werden muss, damit eine Kommunikation der beiden Kanalsysteme realisiert ist.

Eine zur Belüftung vorgesehene Kommunikation des Kanalsystems mit der Umgebung ist mit Hilfe einer Austrittsöffnung der Trägerplatte vorgesehen, welche vorteilhafterweise ein Endbereich eines Kanals des Kanalsystems ist, das an einer Randfläche der Trägerplatte ausgebildet ist. Bevorzugt ist die Austrittsöffnung reversibel verschließbar. Mit anderen Worten ist ein Verschluss, insbesondere ein Druckausgleichselement, vorgesehen, welcher bspw. in Form einer clipähnlichen Abdeckkappe ausgeführt ist, und einfach auf die Austrittsöffnung gesteckt sowie entfernt werden kann. Ebenso kann der Verschluss auch mit Hilfe einer Schraubverbindung an der Trägerplatte zu befestigen sein. Ein Verschluss in Form eines Druckausgleichselements dient bei einem gegenüber Schmutz und Nässe verschlossenem Kanalsystem zur Herbeiführung eines Druckausgleichs, welcher notwendig ist, damit die Lebensdauer nicht aufgrund einer hohen Druckbelastung der Leuchtdiode reduziert ist.

In einer weiteren Ausgestaltung der erfindungsgemäßen Linsenanordnung ist die Trägerplatte aus einem Aluminiumwerkstoff hergestellt. Aluminiumwerkstoffe zeichnen sich allgemein durch ihre geringe Dichte aus, so dass selbst große Bauteile ein gegenüber bspw. Stahl geringes Gewicht aufweisen. Des Weiteren weisen Aluminiumwerkstoffe aufgrund ihrer hohen Wärmeleitfähigkeit ein sehr gutes Preis-Leistungsverhältnis auf, so dass eine kostengünstige Trägerplatte bei gleichzeitig hoher Wärmeabfuhr herstellbar ist.

Die Leiterplatte weist eine elektrische Leitfähigkeit auf. Eine Vergussmasse, welche auf der ersten Leiterplattenfläche in Zwischenräumen der voneinander beabstandeten Linsen vorgesehen ist, dient einer Isolation der Leiterplatte. Die Vergussmasse ist einerseits ein Berührungsschutz für Lebewesen im Hinblick auf die elektrische Leitfähigkeit der Leiterplatte, sowie andererseits ein Schutz zur schmutz- und wasserdichten Verschließung der Hohlräume der Linsen, welche insbesondere in der Schutzverordnung IP66 gefordert ist.

In einer weiteren bevorzugten Ausgestaltung der erfindungsgemäßen Linsenanordnung eine die Trägerplatte vollständig durchdringende Anschlussöffnung in der Trägerplatte ausgebildet. An der ersten Trägerplattenfläche ist die mit den Linsen und Leuchtdioden bestückte Leiterplatte aufgenommen. Eine von der ersten Trägerplattenfläche abgewandt ausgebildete zweite Trägerplattenfläche ist dem Träger der Beleuchtungsvorrichtung zugewandt. Der Träger ist üblicherweise zur Aufnahme elektrischer Leitungen zur Stromversorgung der Linsenanordnung ausgebildet. Mit Hilfe der Anschlussöffnung ist eine gegenüber der Umgebung abgegrenzte und geschützte Durchführung der elektrischen Leitungen ausgehend von dem Träger über die Trägerplatte zur Leiterplatte geschaffen. Zur weiteren Sicherung gegen gegenüber einem Abrieb und demzufolge einer Beschädigung der elektrischen Leitungen weist die Aufnahmeöffnung eine Schutzhülle auf, welche vorteilhafterweise aus einem Kunststoff, idealerweise Gummi hergestellt sind. Gummi bietet den Vorteil, dass er nicht leitfähig ist bei gleichzeitig hoher Elastizität, so dass er formschlüssig und dichtend in die Aufnahmeöffnung eingebracht werden kann.

Ein weiterer Aspekt der Erfindung bezieht sich auf eine Beleuchtungsvorrichtung, mit einer Mehrzahl von Linsenanordnungen, wobei jede Linsenanordnung zumindest eine Leuchtdiode und eine die Leuchtdiode umfassende Linse umfasst, welche auf einer Leiterplatte der Linsenordnung ausgebildet ist. Jede Linsenanordnung ist an einer unabhängig von einem Träger der Beleuchtungsvorrichtung ausgebildeten Trägerplatte aufgenommen. Der Vorteil ist ein modularer Aufbau einer die Gesamtanzahl der Linsenanordnungen umfassenden Lichtquelle, wobei aufgrund des modularen Aufbaus eine kostengünstige, schnelle und einfache Wartung der Beleuchtungsvorrichtung realisiert ist.

Ist beispielweise die Beleuchtungsvorrichtung mit in einer Reihe angeordneter Linsenanordnungen ausgebildet, so ist bei einem Ausfall einer Leuchtdiode nicht die gesamte Lichtquelle aus dem Träger der Beleuchtungsvorrichtung zu entfernen, sondern es kann die Linsenanordnung von der Beleuchtungsvorrichtung ausgewechselt werden, welche die defekte Leuchtdiode aufweist. Dies ist insbesondere dann von Vorteil, sofern die Beleuchtungsvorrichtung große eine Mehrzahl von Linsen mit je einer Leuchtdiode aufweist, wie bspw. Flutleuchten in Stadien, Leuchten im Flughafenbereich oder Tunnelleuchten im insbesondere Kraftfahrzeugverkehr. Es muss nicht die gesamte Lichtquelle ausgewechselt werden, so dass einerseits Materialkosten und andererseits Montagezeiten eingespart werden.

Weitere Vorteile, Merkmale und Einzelheiten der Erfindung ergeben sich aus der nachfolgenden Beschreibung bevorzugter Ausführungsbeispiele sowie anhand der Zeichnung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Gleichen oder funktionsgleichen Elementen sind identische Bezugszeichen zugeordnet. Aus Gründen der Übersichtlichkeit ist es möglich, dass die Elemente nicht in allen Figuren mit ihrem Bezugszeichen versehen sind, ohne jedoch ihre Zuordnung zu verlieren. Es zeigen:
Fig. 1 in einer perspektivischen Ansicht eine erfindungsgemäße Linsenanordnung, und

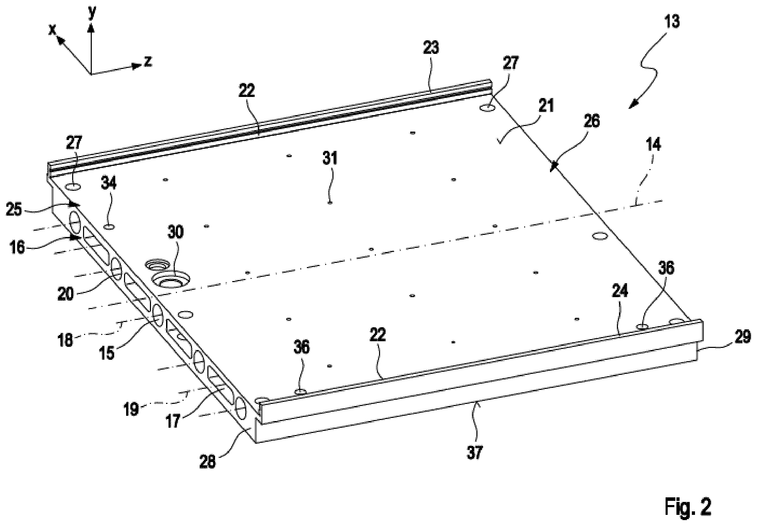

Fig. 2 in einer perspektivischen Ansicht eine Trägerplatte der erfindungsgemäßen Linsenanordnung.

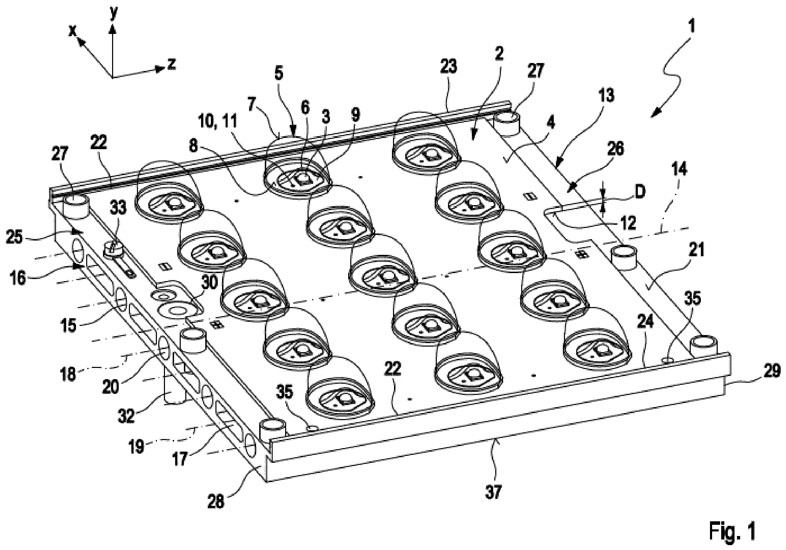

Eine erfindungsgemäße Linsenanordnung 1 für eine Beleuchtungsvorrichtung ist gemäß einer in Fig. 1 dargestellten Struktur aufgebaut. Die Linsenanordnung 1 umfasst eine Leiterplatte 2 mit Leuchtdioden 3, so genannte Primäroptikelemente, welche matrixartig auf einer ersten Leiterplattenfläche 4 der Leiterplatte 2 angeordnet sind. Die Leiterplatte 2 ist als Metallkernplatine ausgebildet, sie kann aber ebenso auch als eine so genannte FR4 Platine ausgestaltet sein. Zur verbesserten Beschreibung ist ein 3-dimensionales kartesisches Koordinatensystem eingezeichnet, mit dessen Hilfe Ausdehnungsrichtungen der Linsenanordnung 1 vereinfacht zu erläutern sind. Das kartesische Koordinatensystem weist eine erste Erstreckungsachse in eine x-Richtung auf, wobei senkrecht hierzu eine zweite Erstreckungsachse in γ-Richtung sowie eine dritte Erstreckungsachse in z-Richtung ausgeführt sind.

Jede der Leuchtdioden 3 ist in einer Linse 5, ein so genanntes Sekundäroptikelement, in einem Hohlraum 6 der Linse 5 aufgenommen. Die Linse 5 ist nach außen gewölbt ausgebildet und weist eine konvexformartige Krümmung ihrer Mantelfläche 7 auf, welche von der Leuchtdiode 3 abgewandt ausgebildet ist. Mit Hilfe einer eben ausgebildeten Positionierfläche 8 ist die Linse 5 auf der Leiterplatte 2 ihren Hohlraum 6 gegenüber der an der Mantelfläche 7 anliegenden Umgebung abdichtend aufgenommen. Die Linse 5 ist mit Hilfe eines Klebmittels auf der Leiterplatte 2 fixiert. Die Linse 5 aus Glas hergestellt.

Die in diesem Ausführungsbeispiel gezeigte Linse 5 ist als beispielhaft anzusehen. Die Linse 5 könnte ebenso einen andere Form aufweisen und/oder aus einem anderen Material, insbesondere aus einem Kunststoff hergestellt sein.

Auf der ersten Leiterplattenfläche 4 ist mit Hilfe des Hohlraums 6 eine Freifläche 9 der Leiterplatte 2 ausgebildet, innerhalb derer die Leuchtdiode 3 platziert ist. In dieser Freifläche 9 ist eine Durchtrittsöffnung 10 positioniert, welche die Leiterplatte 2 in ihrer Dicke D vollständig durchdringt, wobei an der ersten Leiterplattenfläche 4 eine Eintrittsfläche 11 der Durchtrittsöffnung 10 und an einer von der ersten Leiterplattenfläche 4 abgewandt ausgebildete zweiten Leiterplattenfläche 12 eine nicht näher dargestellte Austrittsfläche der Durchtrittsöffnung 10 ausgestaltet ist. Diese Durchtrittsöffnung 10 ist auf einfache Weise in Form einer Bohrung ausgeführt.

Die Leiterplatte 2 ist auf einer Trägerplatte 13 mit Hilfe einer Schraubverbindung angeordnet. Hierzu weist die Leiterplatte 2 zwei die Leiterplatte 2 vollständig in ihrer Dicke D durchdringende Öffnungen 35 auf, die auf der Trägerplatte 13 positioniert mit jeweils einer Ausnehmung 36 der Trägerplatte 13 fluchten. Die Leiterplatte 2 könnte ebenso an der Trägerplatte 13 mit Hilfe einer Klebverbindung befestigt sein. Die Trägerplatte 13 ist zur Wärmeabfuhr einer von den Leuchtdioden 3 erzeugten Wärmemenge ausgebildet. Des Weiteren ist sie zur Belüftung und somit zur Kühlung der Linsenanordnung 1 ausgestaltet.

Die Trägerplatte 13 ist rechteckig ausgebildet und weist zur Positionierung und zur Führungshilfe eine erste Plattenrandkante 23 und eine der ersten Plattenrandkante 23 gegenüberliegende zweite Plattenrandkante 24 auf, zwischen welchen die Leiterplatte 2 angeordnet ist. In ihrer Erstreckung entlang der z-Richtung ist die Trägerplatte 13 größer ausgestaltet als die Leiterplatte 2, wobei an den die Leiterplatte 2 in z-Richtung begrenzende Bereiche, einem ersten Positionierbereich 25 und einem zweiten Positionierbereich 26, Führungselemente 27 zur Aufnahme von nicht näher dargestellten Befestigungselementen zur Befestigung der Linsenanordnung 1 an einem nicht näher dargestellten Träger der Beleuchtungsvorrichtung ausgebildet sind. In einer einfachen Weise ist das Führungselement 27 in Form einer Bohrung ausgebildet, welche eine Schraube als Befestigungselement aufnehmbar ist, so dass die Linsenanordnung 1 mit Hilfe der Schrauben an dem Träger montiert werden kann.

In einer nicht näher dargestellten Ausführungsform ist die Linsenanordnung 1 mit Hilfe einer Klebverbindung an dem Träger aufgenommen. Zur Demontage ist die Klebverbindung zu erhitzen, so dass eine Trag- und Haltefunktion der Klebverbindung aufgelöst wird.

Zur Belüftung ist ein durchströmbares Kanalsystem 16 der Linsenanordnung 1 ausgebildet. Das Kanalsystem 16 umfasst mehrere Kanäle, welche miteinander durchströmbar verbunden sind. Im dargestellten Ausführungsbeispiel weist die Trägerplatte 13 sich entlang einer in z-Richtung ausdehnenden Längsachse 14 der Linsenanordnung 1 erstreckende bohrungsformartig ausgebildete Entlüftungskanäle 15 des Kanalsystems 16 auf. Des Weiteren sind sich entlang der Längsachse 14 erstreckende nutformartige Zusatzkanäle 17 ausgebildet, die ebenfalls einer Entlüftung dienen können, allerdings in diesem Ausführungsbeispiel zur Führung von elektrischen Leitungen zur Stromversorgung der Leuchtdioden 3 ausgebildet sind. Daher sind diese Zusatzkanäle 17 in diesem Ausführungsbeispiel nicht durchströmbar mit den Entlüftungskanälen 15 oder den Durchtrittsöffnungen 10 verbunden.

Das zur Belüftung und somit zur Kühlung der Linsenanordnung 1 ausgebildete durchströmbare Kanalsystem 16 des vorliegenden Ausführungsbeispiels der erfindungsgemäßen Linsenanordnung 1 ist in der Trägerplatte 13 ausgestaltet. Das Kanalsystem 16 umfasst die Entlüftungskanäle 15 und Nebenkanäle 31, welche von den Entlüftungskanälen 15 abzweigend und/oder in die Entlüftungskanäle 15 einmündend ausgebildet sind. Zur Kommunikation des Kanalsystems 16 mit den Durchtrittsöffnungen 10 sind die Austrittsflächen der Durchtrittsöffnungen 10 durchströmbar mit den Nebenkanälen 31 des Kanalsystems 16 verbunden. Mit anderen Worten stellt ein Nebenkanal 31 ein Verbindungskanal zwischen der Austrittsfläche bzw. der Durchtrittsöffnung 10 und einem Entlüftungskanal 15 dar. Ebenso könnte allerdings auch ein Nebenkanal ausgebildet sein, welcher zwischen einzelnen Entlüftungskanälen 18 und/oder Zusatzkanälen 17 in Form eines Verbindungskanals positioniert ist. Zur vereinfachten Herstellung des Kanalsystems 16 ist es daher vorgesehen, dass die Durchtrittsöffnungen 10 entlang einer Entlüftungskanalachse 18 des Entlüftungskanals 15 und/oder einer Zusatzkanalachse 19 des Zusatzkanals 17 angeordnet sind.

Die Trägerplatte 13 weist eine Austrittsöffnung 20 des Kanalsystems 16 auf, welche zur Entlüftung mit der Umgebung kommunizierend ausgebildet ist. In diesem Ausführungsbeispiel sind Enden der Entlüftungskanäle 15 jeweils als Austrittsöffnung 20 ausgeführt. Diese Austrittsöffnungen 20 können geöffnet bleiben, sofern die Linsenanordnung 1 in einem Innenbereich, somit in einem Bereich, welcher insbesondere vor Nässe geschützt ist, eingesetzt wird. Sofern die Linsenanordnung 1 in einem Außenbereich eingesetzt wird, sind die Austrittsöffnungen 20 mit Hilfe von Druckausgleichselementen zu schließen, so dass selbst bei geschlossenen Austrittsöffnungen ein Druckausgleich im Kanalsystem 16 und in den Hohlräumen 6 zur Funktionserhaltung der Linsenanordnung 1 stattfinden kann. Diese Druckausgleichselemente sind nicht zwingend unlösbar mit der Trägerplatte 13 verbunden, das heißt, die Austrittsöffnungen 20 sind reversibel verschließbar.

Im Weiteren dienen die Entlüftungskanäle 15 und Zusatzkanäle 17 einer Gewichtsreduzierung der Trägerplatte 13 und somit der gesamten Linsenanordnung 1. Ihre Ausdehnungsparameter, wie bspw. Länge und Durchmesser bzw. Querschnittsfläche, ist lediglich an Mindestgrößen gebunden, welche bei Betrieb der Linsenanordnung 1 eine ausreichende Wärmeabfuhr der durch die Leuchtdioden 3 erzeugten Wärme sicherstellt.

In einem nicht näher dargestellten Ausführungsbeispiel weist die Leiterplatte 2 ein weiteres Kanalsystem zur Be- und/oder Entlüftung auf, welches mit dem Kanalsystem 16 der Trägerplatte 13 sowie mit den Austrittsflächen der Durchtrittsöffnungen 10 kommuniziert. Dieses weitere Kanalsystem ist an der zweiten Leiterplattenfläche 12 ausgebildet. Es sind hierzu Nutkanäle an der zweiten Leiterplattenfläche 12 in die Leiterplatte 2 eingebracht, welche ausgehend von den Austrittsöffnungen netzartig miteinander verbunden sind. Die Trägerplatte 13 weist an ihrer der zweiten Leiterplattenfläche 12 zugewandt ausgebildeten erste Trägerplattenfläche 21 mindestens einen Nebenkanal 31 auf, der über einen Entlüftungskanal 15 mit dem weiteren Kanalsystem durchströmbar verbunden ist. Der Entlüftungskanal 15 weist die zum mit der Umgebung vorgesehenen Energieaustausch relevante Austrittsöffnung 20 auf.

Die Leiterplatte 2 weist an ihrer ersten Leiterplattenfläche 4 eine die Linsen 5 einbettende, nicht näher dargestellte Vergussmasse auf. Die Vergussmasse erstreckt sich in Richtung der γ-Koordinate ausgehend von der ersten Leiterplattenfläche 4 bis zu einer Trägerplattenrandkante 22 der ersten Plattenrandkante 23 bzw. der zweiten Plattenrandkante 24. In ihrer Ausdehnung in Richtung der x-Koordinate ist die Vergussmasse von der ersten Plattenrandkante 23 und der zweiten Plattenrandkante 24 begrenzt, wohingegen sie sich in Richtung der z-Koordinate ausgehend von einem ersten Plattenrandende 28 der Trägerplatte 13 bis zu einem zweiten Plattenrandende 29 der Trägerplatte 13 erstreckt, so dass die Trägerplatte 13 nahezu vollständig mit der Vergussmasse bedeckt ist.

In der Regel ist eine dünnflüssige Vergussmasse eingesetzt, welche in mehreren Schichten aufgetragen wird. Nach einer Bestückung der Leiterplatte 2 mit den Leuchtdioden 3 und den Linsen 5 sowie einer Positionierung der stromversorgenden Kabel erfolgt ein so genannter Vorverguss, welcher nach ca. 4 Stunden Trocknungsverweilzeit mit einem Hauptverguss versehen wird. Eine Gesamttrocknungszeit beträgt ca. 24 Stunden, die unter Zuhilfenahme von Wärmezufuhr, bspw. mit Hilfe beheizter Räumlichkeiten, in denen die Linsenanordnung 1 zur Trocknung aufbewahrt ist, reduziert werden kann.

Die Vergussmasse baut eine permanente Haftung zur Linse 5 auf, weiche bevorzugt aus Glas hergestellt ist, so dass weder Feuchtigkeit noch Staub oder Schmutz über die Linse 5 zur Leuchtdiode 3 eindringen können. Die Vergussmasse weist eine hohe chemische Beständigkeit auf. Eine gute Haftung der Vergussmasse an der Trägerplatte 13 kann durch eine entsprechende Vorbehandlung der Trägerplatte 13 erzielt werden. Eine mechanische Struktur der Vergussmasse ist so gestaltet, das eine Resteiastizität selbst bei -40°C nicht zu Versprödungen des Materials führt. Eine thermische Beständigkeit ist trotz der Elastizität des Materials bis 140°C gegeben. Aufgrund der epoxidhaltigen Struktur ergibt sich eine ausgezeichnete Haftung zur Leiterplatte, was einen stabilen und permanenten Verbund garantiert. Rohstoffe zur Herstellung der Vergussmasse sind so gewählt, das Umwelteinflüsse während der Aushärtung wie feuchte Umgebung keinen wesentlichen Einfluss auf die optische Erscheinung ausüben.

Damit eine elektrische Stromversorgung der Leuchtdioden 3 ebenfalls vor Nässe und Schmutz geschützt sind, weist die Trägerplatte 13 eine die Trägerplatte 13 vollständig durchdringende Anschlussöffnung 30 auf. In diese Anschlussöffnung 30 ist ein Aufnahmeelement 32 eingeführt, welches als Kunststoffbauteil hergestellt ist und einem Sicherheitsschutz von elektrischen Leitungen gegenüber Berührungen mit im Allgemeinen scharfen Kanten der Anschlussöffnung 30 dient.

Im zweiten Positionierbereich 26 ist zur Erdung ein Masseanschluss 33 als Schutz gegenüber der elektrisch leitfähigen Trägerplatte 13 vorgesehen, der in einer Aufnahmeausnehmung 34 aufgenommen ist.

Die Trägerplatte 13 des dargestellten Ausführungsbeispiels ist in Form eines Strangpressteils aus einem Aluminiumwerkstoff hergestellt. Somit erfüllt die Trägerplatte 13 aufgrund des eingesetzten Aluminiumwerkstoffs neben ihrer Halte-, Montier- und Belüftungsfunktion auch eine wärmeabführende Funktion.

Der Vorteil einer Herstellung der Trägerplatte 13 in einem Strangpressverfahren ist darin zu sehen, dass während des Strangpressverfahrens die Belüftungskanäle bzw. das Kanalsystem integriert hergestellt werden können, so dass ein zusätzlicher Arbeitsschritt, bspw. Bohren oder Fräsen entfällt. Das Kanalsystem 16 und das weitere Kanalsystem kann mittels einer mechanischen spanenden Bearbeitung wie bspw. Bohren, Fräsen, in die Trägerplatte 13 oder die Leiterplatte 2 eingebracht werden. Ebenso kann das Kanalsystem 16 bei der Herstellung der Trägerplatte 13 in einem Strangpressverfahren oder einem Gussverfahren wie bspw. einem Druckguss hergestellt werden.

Die Linsenanordnung 1 ist auf einfache Weise, bspw. mittels einer Schraubverbindung an einem Träger der Beleuchtungsvorrichtung zu montieren sowie zu demontieren, so dass auch ein Wartungsaufwand wesentlich reduziert ist.

Die Trägerplatte 13 ist dem Träger der Beleuchtungsvorrichtung zugewandt angeordnet, derart, dass eine von der ersten Trägerplattenfläche 21 abgewandt ausgebildeten zweiten Trägerplattenfläche 37 der Trägerplatte 13 einer nicht näher dargestellten Trägerfläche des Trägers gegenüberliegend positioniert ist. Vorteilhafterweise sind die zweite Trägerplattenfläche 37 und die Trägerfläche einander kontaktierend, so dass eine weitere Wärmeableitung aufgrund von Wärmeleitung ausgehend von der Trägerplatte 13 über den Träger erfolgen kann.

Die Linsenanordnung 1 ist bei einer Positionierung mehrerer Linsenanordnungen 1 an einem Träger der Beleuchtungsvorrichtung so auszurichten, dass sich Austrittsöffnungen der Belüftungs- und Zusatzkanäle durchströmbar gegenüberliegen, so dass eine durchgehende Belüftung der gesamten, an dem Träger aufgenommenen Linsenanordnungen 1 sichergestellt werden kann.

### BEZUGSZEICHENLISTE

- 1: Linsenanordnung
- 2: Leiterplatte
- 3: Leuchtdiode
- 4: Erste Leiterplattenfläche
- 5: Linse
- 6: Hohlraum
- 7: Mantelfläche
- 8: Positionierfläche
- 9: Freifläche
- 10: Durchtrittsöffnung
- 11: Eintrittsfläche
- 12: Zweite Leiterplattenfläche
- 13: Trägerplatte
- 14: Längsachse
- 15: Entlüftungskanal
- 16: Kanalsystem
- 17: Zusatzkanal
- 18: Entlüftungskanalachse
- 19: Zusatzkanalachse v
- 20: Austrittsöffnung
- 21: Erste Trägerplattenfläche
- 22: Trägerplattenrandkante
- 23: Erste Plattenrandkante
- 24: Zweite Plattenrandkante
- 25: Erster Positionierbereich
- 26: Zweiter Positionierbereich
- 27: Führungselement
- 28: Erster Plattenrandbereich
- 29: Zweiter Plattenrandbereich
- 30: Anschlussöffnung
- 31: Nebenkanal
- 32: Aufnahmeelement
- 33: Masseanschluss
- 34: Aufnahmeausnehmung
- 35: Öffnung
- 36: Ausnehmung
- 37: Zweite Trägerplattenfläche
- D: Dicke

## Patentansprüche

1. Beleuchtungsvorrichtung, umfassend
(i) eine Linsenanordnung (1),
(ii) eine Leuchtdiode (3), welche auf einer Leiterplatte (2) fixiert ist,
(iii) wobei die Leuchtdiode (3) an einer ersten Leiterplattenfläche (4) der Leiterplatte (2) ausgebildet ist, und wobei
(iv) die Leuchtdiode (3) von einer Linse (5) in einem Hohlraum (6) der Linse (5) von dieser umfassend aufgenommen ist, und wobei
(v) die Linse (5) eine der Leuchtdiode (3) zugewandt ausgebildete ebene Positionierfläche (8) aufweist, welche an der ersten Leiterplattenfläche (4) fixiert ist, wobei
(a) die Linsenanordnung (1) eine Trägerplatte (13) aufweist, welche mit einem Träger der Beleuchtungsvorrichtung lösbar verbindbar ist, wobei
(b) die Trägerplatte (13) die Leiterplatte (2) aufnehmbar ausgebildet ist, **dadurch gekennzeichnet, dass** die Trägerplatte (13)
(c) eine Austrittsöffnung (20) eines zur Belüftung vorgesehenen Kanalsystems (16) aufweist, welche mit der Umgebung kommunizierend ausgebildet ist, und ein Druckausgleichselement als Verschluss aufweist.

2. Beleuchtungsvorrichtung nach Anspruch 1, **dadurch gekennzeichnet, dass** die Leiterplatte (2) eine Mehrzahl von Linsen (5) aufweisend je eine Leuchtdiode (3) umfasst.

3. Beleuchtungsvorrichtung nach Anspruch 2, **dadurch gekennzeichnet, dass** die Mehrzahl von Linsen (5) matrixartig auf der Leiterplatte (2) angeordnet sind.

4. Beleuchtungsvorrichtung nach einem der vorherigen Ansprüche, **dadurch gekennzeichnet, dass** die Trägerplatte (13) zur Wärmeabfuhr einer von der Leuchtdiode (3) erzeugten Wärmemenge ausgebildet ist.

5. Beleuchtungsvorrichtung nach einem der vorherigen Ansprüche, **dadurch gekennzeichnet, dass** die Trägerplatte (13) ein Kanalsystem (16) zur Belüftung der Linsenanordnung (1) aufweist.

6. Beleuchtungsvorrichtung nach einem der vorherigen Ansprüche, **dadurch gekennzeichnet, dass** der Hohlraum (6) eine Freifläche (9) der ersten Leiterplattenfläche (4) begrenzt, innerhalb derer die Leuchtdiode (3) positioniert ist, und wobei innerhalb dieser Freifläche (9) eine die Leiterplatte (2) vollständig durchdringende Durchtrittsöffnung (10) mit einer an der ersten Leiterplattenfläche (4) ausgebildeten Eintrittsfläche (11) und einer an einer von der ersten Leiterplattenfläche (4) abgewandt ausgebildeten zweiten Leiterplattenfläche (12) ausgebildeten Austrittsfläche ausgestaltet ist, wobei die Austrittsfläche mit einem zumindest teilweise in der Trägerplatte (13) ausgebildeten Kanalsystem (16) zur Belüftung kommunizierend ausgestaltet ist.

7. Beleuchtungsvorrichtung nach Anspruch 6, **dadurch gekennzeichnet, dass** ausgehend von der Austrittsfläche ein mit dem Kanalsystem (16) kommunizierendes weiteres Kanalsystem an der zweiten Leiterplattenfläche (12) ausgebildet ist.

8. Beleuchtungsvorrichtung nach einem der vorherigen Ansprüche, **dadurch gekennzeichnet, dass** die Trägerplatte (13) aus einem Aluminiumwerkstoff hergestellt ist.

9. Beleuchtungsvorrichtung nach einem der vorherigen Ansprüche, **dadurch gekennzeichnet, dass** die Trägerplatte (13) in Form eines Druckgussbauteils hergestellt ist.

10. Beleuchtungsvorrichtung nach einem der vorherigen Ansprüche, **dadurch gekennzeichnet, dass** die Leiterplatte (2) an ihrer ersten Leiterplattenfläche (4) eine die Linse (5) einbettende Vergussmasse aufweist.

11. Beleuchtungsvorrichtung nach einem der vorherigen Ansprüche, **dadurch gekennzeichnet, dass** die Trägerplatte (13) eine die Trägerplatte (13) vollständig durchdringende Anschlussöffnung (30) zur elektrischen Stromversorgung der Leuchtdioden (3) aufweist.

12. Beleuchtungsvorrichtung nach einem der vorherigen Ansprüche, **dadurch gekennzeichnet, dass** die Linse (5) eine konvexformartige Krümmung ihrer Mantelfläche (7) aufweist, welche von der Leuchtdiode (3) abgewandt ausgebildet ist

## Claims

1. A lighting device, comprising
(i) an array of lenses (1),
(ii) a light-emitting diode (3) fixed onto a circuit board (2),
(iii) wherein said light-emitting diode (3) is formed at a first circuit board surface (4) of said circuit board (2), and wherein
(iv) said light-emitting diode (3) is received by a lens (5) in a cavity (6) of said lens (5), surrounded by it, and wherein
(v) said lens (5) has a planar positioning surface (8) formed to face said light-emitting diode (3) and fixed to said first circuit board surface (4), wherein
(a) said array of lenses (1) has a support plate (13) that can be detachably connected with a support of said lighting device, wherein
(b) said support plate (13) is formed to be able to receive the circuit board (2), **characterized in that** said support plate (13)
(c) has an outlet opening (20) of a channel system (16) provided for aeration formed to communicate with the environment, and a pressure equalization element as a closure.

2. The lighting device according to claim 1, **characterized in that** said circuit board (2) comprises a plurality of lenses (5) each having a light-emitting diode (3).

3. The lighting device according to claim 2, **characterized in that** said plurality of lenses (5) are arranged in an array on said circuit board (2).

4. The lighting device according to any of the preceding claims, **characterized in that** said support plate (13) is formed for dissipating the amount of heat generated by said light-emitting diode (3).

5. The lighting device according to any of the preceding claims, **characterized in that** said support plate (13) has a channel system (16) for aerating said array of lenses (1).

6. The lighting device according to any of the preceding claims, **characterized in that** said cavity (6) bounds a free area (9) of said first circuit board surface (4) within which said light-emitting diode (3) is positioned, and wherein, within said free area (9), through hole (10) completely penetrating said circuit board (2) and comprising an entry area (11) formed at the first circuit board surface (4) and an exit area formed at a second circuit board surface (12) facing away from said first circuit board surface (4), wherein said exit area is formed to communicate with a channel system (16) for aeration at least partially formed in said support plate (13).

7. The lighting device according to claim 6, **characterized in that** a further channel system communicating with said channel system (16) is formed at said second circuit board surface (12), starting from said exit area.

8. The lighting device according to any of the preceding claims, **characterized in that** said support plate (13) is made of an aluminum material.

9. The lighting device according to any of the preceding claims, **characterized in that** said support plate (13) is made in the form of a die-cast component.

10. The lighting device according to any of the preceding claims, **characterized in that** said circuit board (2) has a casting composition embedding said lens (5) at its first circuit board surface (4).

11. The lighting device according to any of the preceding claims, **characterized in that** said support plate (13) has a connecting opening (30) completely penetrating said support plate (13) for supplying said light-emitting diodes (3) with electric power.

12. The lighting device according to any of the preceding claims, **characterized in that** said lens (5) has a convex-like curvature of its lateral surface (7), which is formed to face away from said light-emitting diode (3).

## Revendications

1. Dispositif d'illumination, comprenant
(i) un arrangement de lentilles (1),
(ii) une diode électroluminescente (3) fixée sur une carte de circuit (2),
(iii) dans lequel ladite diode électroluminescente (3) est formée sur une première surface de carte de circuit (4) de ladite carte de circuit (2), et dans lequel
(iv) ladite diode électroluminescente (3) est reçue d'une lentille (5) dans une cavité (6) de ladite lentille (5), enfermée par la dernière, et dans lequel
(v) ladite lentille (5) présente une surface de positionnement planaire (8), formée dans une position tournée vers ladite diode électroluminescente (3), et fixée sur ladite première surface de carte de circuit (4), dans lequel
(a) ledit arrangement de lentilles (1) présente une plaque de support (13) qui peut être liée avec un support du dispositif d'illumination dans une manière amovible, dans lequel
(b) ladite plaque de support (13) est formée de manière qu'elle puisse recevoir ladite carte de circuit (2), **caractérisé en ce que** ladite plaque de support (13)
(c) présente une ouverture de sortie (20) d'un système de canaux (16) prévu pour l'aération, formée de manière qu'elle communique avec l'ambiante, et présente un élément d'égalisation de pression en tant que fermeture.

2. Dispositif d'illumination selon la revendication 1, **caractérisé en ce que** ladite carte de circuit (2) comprend une pluralité de lentilles (5), chacune présentant une diode électroluminescente (3).

3. Dispositif d'illumination selon la revendication 2, **caractérisé en ce que** ladite pluralité de lentilles (5) est arrangée sur ladite carte de circuit (2) sous forme d'un réseau.

4. Dispositif d'illumination selon l'une quelconque des revendications précédentes, **caractérisé en ce que** ladite plaque de support (13) est formée pour la dispersion d'une quantité de chaleur telle que produite par ladite diode électroluminescente (3).

5. Dispositif d'illumination selon l'une quelconque des revendications précédentes, **caractérisé en ce que** ladite plaque de support (13) présente un système de canaux (16) pour l'aération de l'arrangement de lentilles (1).

6. Dispositif d'illumination selon l'une quelconque des revendications précédentes, **caractérisé en ce que** ladite cavité (6) limite un espace libre (9) de ladite première surface de carte de circuit (4), dans lequel ladite diode électroluminescente (3) est positionnée, et dans lequel un trou de passage (10) pénétrant complètement ladite carte de circuit (2) est formé au sein dudit espace libre (9) avec une surface d'entrée formée sur ladite première surface de carte de circuit (4) et une surface de sortie formée sur la seconde surface de carte de circuit (12), formée d'une manière orientée à l'opposé de ladite première surface de carte de circuit (4), dans lequel la surface de sortie est formée pour communiquer avec un système de canaux (16) formé au moins partiellement dans ladite plaque de support (13) pour l'aération.

7. Dispositif d'illumination selon la revendication 6, **caractérisé en ce qu'**un autre système de canaux communiquant avec ledit système de canaux (16) est formé sur ladite seconde surface de carte de circuit (12), à partir de la surface de sortie.

8. Dispositif d'illumination selon l'une quelconque des revendications précédentes, **caractérisé en ce que** ladite plaque de support (13) est fabriquée en un matériau d'aluminium.

9. Dispositif d'illumination selon l'une quelconque des revendications précédentes, **caractérisé en ce que** ladite plaque de support (13) est fabriquée sous forme d'un composant coulé sous pression.

10. Dispositif d'illumination selon l'une quelconque des revendications précédentes, **caractérisé en ce que** ladite carte de circuit (2) présente une composition de coulée encastrant ladite lentille (5) sur ladite première surface de carte de circuit (4).

11. Dispositif d'illumination selon l'une quelconque des revendications précédentes, **caractérisé en ce que** ladite plaque de support (13) présente une ouverture de connexion (30) pénétrant complètement ladite plaque de support (13) pour l'alimentation électrique des diodes électroluminescentes (3).

12. Dispositif d'illumination selon l'une quelconque des revendications précédentes, **caractérisé en ce que** ladite lentille (5) présente une courbure similaire à une forme convexe de sa surface latérale formée dans une orientation à l'opposé de ladite diode électroluminescente (3).
